# EUROPEAN PATENT SPECIFICATION

(11) **EP 4 002 964 B1**
(45) Date of publication and mention of the grant of the patent: **27.09.2023**
(21) Application number: 21199542.8
(22) Date of filing: 28.09.2021
(51) Int. Cl.: H05K 5/02, H05K 5/03

(54) **POWER CONVERSION DEVICE**
STROMUMWANDLUNGSVORRICHTUNG
DISPOSITIF DE CONVERSION D'ALIMENTATION ÉLECTRIQUE

(30) Priority: 20.11.2020 JP 2020193193
(43) Date of publication of application: 25.05.2022
(73) Proprietor: Fuji Electric Co., Ltd., Kawasaki-shi, Kanagawa 210-9530 (JP)
(72) Inventor: NAKATA, Toshiyuki, Kawasaki-shi, Kanagawa, 210-9530 (JP); SATAKE, Shuhei, Kawasaki-shi, Kanagawa, 210-9530 (JP); URUMA, Tomoki, Kawasaki-shi, Kanagawa, 210-9530 (JP)
(74) Representative: Appelt, Christian W.

(56) References cited:
- FR-A3- 2 814 321

## Description

### [Technical Field]

The present invention relates to a power conversion device, and in particular, to a power conversion device provided with a connection portion for connection of external equipment.

### [Background Art]

In the related art, a power supply device provided with a connection terminal for connection of an external device is known. Such a power supply device is disclosed in, for example, JP-A-2020-054179.

The power supply device described in JP-A-2020-054179 described above includes a rectifier circuit, a metal-oxide-semiconductor field-effect transistor (MOSFET), and a power supply unit including a transformer. The power supply unit converts alternating-current power from an alternating-current power supply into direct-current power and outputs direct-current power. The power supply device is provided with a connection terminal and is configured to perform communication with an external device, such as a personal computer (PC), by a connection cable. The power supply device described in JP-A-2020-054179 described above is configured to receive a signal from the external device as input and output information to the external device.

Here, the power supply device (power conversion device) described in JP-A-2020-054179 described above may be provided in an environment in which foreign substances, such as powder dust, are included in the atmosphere, such as the inside of a factory or outdoors. In this case, to suppress mixing of foreign substances with a portion (connection portion) for connection of external equipment, such as a connection terminal provided in an exterior surface of the power supply device, it is considered that a cover member for covering the connection portion is provided. Note that, in a case where the cover member for covering the connection portion is provided, there is a problem in that, the number of components increases and a burden of assembling work increases due to a new configuration (member), such as a fastening member (screw), that is provided to fix the cover member to the exterior surface of the power supply device.

FR 2 814 321 A3 describes a connection box. The box has a body and a cover with a seal beneath. The cover is attached to the body by hinges. The hinges include a sliding mount, which allows the cover to be drawn out perpendicular to the plane of the box.

### [Summary of the Invention]

The invention has been accomplished to solve the problem described above, and an object of the invention is to provide a power conversion device capable of, even in a case where a cover member for covering a connection portion for connection of external equipment is provided, easily performing assembling work without causing an increase in the number of components to fix a cover member.

To achieve the above-described object, the present invention relates to a power conversion device according to claim 1. Claims 2 to 14 refer to specifically advantageous realizations of the power conversion device according to claim 1.

A power conversion device according to an aspect of the invention includes a housing for power conversion that includes an exterior surface portion provided with a connection portion for connection of external equipment and in which a power conversion unit configured to perform a power conversion operation to convert input power and output converted power is disposed, and a cover member including a lid portion for covering the connection portion and an elastically deformable fixing portion for fixing the cover member to the housing for power conversion. The cover member is attached to the exterior surface portion by the fixing portion being inserted into an insertion portion provided in the exterior surface portion separately from the connection portion while being elastically deformed, and any one portion of the fixing portion of the cover member and an interior surface of the insertion portion provided in the exterior surface portion is provided with a protrusion portion that is brought into contact with the other portion and has a width smaller than a width of the fixing portion in a direction perpendicular to a direction in which the protrusion portion is brought into contact with the other portion.

In the power conversion device according to the aspect of the invention, as described above, the cover member is attached to the exterior surface portion by the fixing portion of the cover member being inserted into the insertion portion provided in the exterior surface portion separately from the connection portion while being elastically deformed. Then, any one portion of the fixing portion of the cover member and the interior surface of the insertion portion provided in the exterior surface portion is provided with the protrusion portion that is brought into contact with the other portion and has the width smaller than the width of the fixing portion in the direction perpendicular to the direction in which the protrusion portion is brought into contact with the other portion. With this, the protrusion portion provided in any one portion of the fixing portion and the interior surface of the insertion portion can be brought into contact with the other portion of the fixing portion and the interior surface of the insertion portion to press down the fixing portion. That is, the fixing portion is press-fitted into the insertion portion. For this reason, unlike a case where a fastening member (screw) or the like is separately provided to fix the fixing portion inserted into the insertion portion is separately provided, it is possible to fix and attach the cover member to the housing for power conversion with the interior surface of the insertion portion provided in the exterior surface portion of the housing for power conversion and the fixing portion of the cover member without providing a new member, such as a screw. In a case of inserting the fixing portion into the insertion portion and fixing the fixing portion, the fixing portion is inserted into the insertion portion while being pressed down by the protrusion portion having a width smaller than the width of the fixing portion. For this reason, it is possible to reduce an area of a contact surface of the fixing portion and the interior surface of the insertion portion through the protrusion portion. Since the width of the protrusion portion is smaller than the width of the fixing portion, it is possible to easily elastically deform the fixing portion in inserting the fixing portion into the insertion portion. With this, since it is possible to reduce force needed for press-fitting in a case of inserting the fixing portion into the insertion portion, it is possible to easily perform assembling work for inserting and fixing the fixing portion. As a result, even in a case where the cover member for covering the connection portion for connection of the external equipment is provided, it is possible to easily perform assembling work without causing an increase in the number of components to fix the cover member.

In the power conversion device according to the above-described aspect, preferably, the protrusion portion provided in any one portion of the fixing portion and the interior surface of the insertion portion has a surface shape with chamfered corners or a rounded surface shape. With this configuration, unlike a case where corners are included in the surface shape of the protrusion portion, it is possible to suppress damage to a surface that is brought into contact with the protrusion portion, on a surface of any portion where the protrusion portion is not provided, of the fixing portion and the interior surface of the insertion portion. For this reason, it is possible to suppress deterioration of a surface portion of the fixing portion or the interior surface of the insertion portion due to damage caused by the corners of the protrusion portion.

In this case, preferably, the protrusion portion has a semicircular surface shape and is provided to be brought into contact with the other portion through a semicircular curved surface of the protrusion portion. With this configuration, since the protrusion portion is brought into contact through the semicircular curved surface, it is possible to bring the protrusion portion into contact with any one portion of the fixing portion and the interior surface of the insertion portion through line contact. For this reason, it is possible to reduce frictional force in inserting the fixing portion compared to a case where the protrusion portion is in surface contact with any one portion of the fixing portion and the interior surface of the insertion portion. Since the protrusion portion having the semicircular surface shape is brought into contact with the fixing portion and the interior surface of the insertion portion, even in a case where the protrusion portion is brought into contact with any portion of the fixing portion and the interior surface of the insertion portion, it is possible to easily elastically deform the fixing portion along the semicircular surface. As a result, since it is possible to further reduce the magnitude of force needed in inserting the fixing portion with the semicircular surface shape of the protrusion portion, it is possible to more easily perform assembling work for fixing the cover member by inserting the fixing portion into the insertion portion.

In the power conversion device according to the above-described aspect, preferably, the protrusion portion provided in any one portion of the fixing portion and the interior surface of the insertion portion has a width in a direction perpendicular to a direction in which the protrusion portion is brought into contact with the other portion, smaller than a corresponding width of the fixing portion within a plane perpendicular to a direction in which the fixing portion is inserted. Here, in a case where the width of the protrusion portion in the direction perpendicular to the direction in which the protrusion portion is brought into contact with the other portion is greater than the corresponding width of the fixing portion within the plane perpendicular to the direction in which the fixing portion is inserted, there is a need to make the size of an opening of the insertion portion greater than needed, to provide the protrusion portion having a large width. In contrast, in the invention, the protrusion portion is configured such that the width in the direction perpendicular to the direction in which the protrusion portion is brought into contact with the other portion is smaller than the corresponding width of the fixing portion within the plane perpendicular to the direction in which the fixing portion is inserted. With this configuration, unlike a case where the protrusion portion having a large width is provided, since there is no need to make the size of the opening of the insertion portion greater than needed, to provide the protrusion portion, it is possible to suppress an increase in size of a device configuration to fix the cover member.

In the power conversion device according to the above-described aspect, preferably, the protrusion portion is provided in the interior surface of the insertion portion, the fixing portion includes a first engagement portion that is inserted into the insertion portion and is engaged with the exterior surface portion, and the interior surface of the insertion portion has a second engagement portion that is engaged with the first engagement portion. With this configuration, it is possible to bring the fixing portion into contact with the protrusion portion provided in the interior surface of the insertion portion in a state in which the first engagement portion of the fixing portion is engaged with the second engagement portion of the interior surface of the insertion portion. For this reason, the protrusion portion provided in the interior surface of the insertion portion presses the fixing portion, whereby it is possible to suppress disengagement of the first engagement portion and the second engagement portion. As a result, it is possible to suppress detachment of the fixing portion from the insertion portion with the protrusion portion.

In this case, preferably, the insertion portion is provided to pass through the exterior surface portion, and the protrusion portion is provided in the interior surface of the insertion portion to be brought into contact with the fixing portion in a state in which the first engagement portion inserted into the insertion portion passing through the exterior surface portion is engaged with the second engagement portion. With this configuration, the insertion portion is provided as a through-hole, whereby it is possible to insert the fixing portion from one end portion to the other end portion of the through-hole to engage the first engagement portion with the other end portion. For this reason, unlike a case where the insertion portion is a recess portion without passing through the exterior surface portion, it is possible to easily configure the interior surface of the end portion of the through-hole as the second engagement portion by providing the insertion portion as a through-hole. As a result, it is possible to easily fix the fixing portion by engaging the fixing portion with the insertion portion.

In the power conversion device in which the above-described protrusion portion is provided in the interior surface of the insertion portion, preferably, the protrusion portion is provided to be brought into contact with the fixing portion on one side in a direction intersecting a direction in which the fixing portion is inserted, in the interior surface of the insertion portion, and the first engagement portion is engaged with the second engagement portion provided on the other side in the direction intersecting the direction in which the fixing portion is inserted, in the interior surface of the insertion portion. With this configuration, since the protrusion portion is provided in the interior surface on a side opposite to the interior surface of the insertion portion provided with the second engagement portion with which the first engagement portion is engaged, it is possible to fix the fixing portion while pressing down the fixing portion from a side opposite to the first engagement portion by bringing the fixing portion into contact with the protrusion portion. For this reason, since the fixing portion is pressed down from the opposite side by the protrusion portion, it is possible to further suppress disengagement of the first engagement portion and the second engagement portion. As a result, it is possible to further suppress detachment of the fixing portion from the insertion portion with the protrusion portion.

In the power conversion device in which the above-described protrusion portion is provided in the interior surface of the insertion portion, preferably, the protrusion portion is provided in the interior surface of the insertion portion such that a distance between the protrusion portion and the second engagement portion is smaller than a thickness of a portion of the fixing portion that is brought into contact with the protrusion portion in a direction in which the protrusion portion is brought into contact with the fixing portion. With this configuration, since the distance between the protrusion portion and the second engagement portion is smaller than the thickness of the fixing portion, it is possible to fix the fixing portion inserted into the insertion portion while being brought into contact with the protrusion portion, while being elastically deformed by the protrusion portion. For this reason, it is possible to more effectively suppress disengagement of the first engagement portion and the second engagement portion with restoring force of the fixing portion fixed while being elastically deformed.

In the power conversion device in which the above-described protrusion portion is provided in the interior surface of the insertion portion, preferably, the insertion portion has a rectangular shape as viewed from a direction in which the fixing portion is inserted, and the protrusion portion is provided on one side between long sides of the rectangular shape in the interior surface of the insertion portion. With this configuration, since a gap of the protrusion portion on the long side, a portion other than the protrusion portion on the long side, and the fixing portion is made large compared to a case where the protrusion portion is provided on a short side of the rectangular shape, it is possible to elastically deform the fixing portion more largely. For this reason, since the fixing portion is fixed to the insertion portion in a state in which greater restoring force is biased to the fixing portion elastically deformed, it is possible to further suppress disengagement of the first engagement portion and the second engagement portion with greater force.

In the specification, the "rectangular shape" is described as a broad concept including not only a rectangular shape having four corners at right angles but also a shape in which four corners are rounded or chamfered. The "rectangular shape" is described as a broad concept including not only a rectangular shape having four corners at right angles but also a quadrangular shape having four corners at angles deviated from right angles.

In the power conversion device in which the above-described protrusion portion is provided in the interior surface of the insertion portion, preferably, the protrusion portion is provided to extend from one end portion side to the other end portion side of the interior surface of the insertion portion along a direction in which the fixing portion is inserted, in the interior surface of the insertion portion. With this configuration, it is possible to further elastically deform the fixing portion compared to a case where the protrusion portion is provided only in a portion in the direction in which the fixing portion is inserted. For this reason, since it is possible to further bias restoring force with the fixing portion further elastically deformed, it is possible to more effectively suppress disengagement of the first engagement portion and the second engagement portion.

In the power conversion device according to the above-described aspect, preferably, the housing for power conversion includes an operation panel that controls the power conversion operation of the power conversion unit, and the protrusion portion is provided in the interior surface of the insertion portion provided in the exterior surface portion as an operation surface of the operation panel. With this configuration, even in a case where the connection portion for connection of the external equipment is provided in the operation surface of the operation panel where the power conversion operation is controlled, it is possible to easily fix the cover member without providing a new configuration (member). For this reason, it is possible to easily perform assembling work of the operation panel without causing an increase in the number of components of the operation panel.

In the power conversion device according to the above-described aspect, preferably, the cover member includes the fixing portion formed of elastically deforming rubber and is attached to the exterior surface portion by the fixing portion being press-fitted and inserted into the insertion portion while being elastically deformed, and the protrusion portion is provided in the interior surface of the insertion portion and is provided to be brought into contact with the fixing portion inserted while being elastically deformed. With this configuration, since the fixing portion is formed of rubber, it is possible to easily elastically deform the fixing portion. For this reason, since it is possible to easily elastically deform and press down the fixing portion in a state of being brought into contact with the protrusion portion, it is possible to easily fix and attach the cover member to the housing for power conversion.

In this case, preferably, the cover member is configured such that the lid portion is openable and closeable in a state in which the cover member is attached to the exterior surface portion, by the elastically deforming fixing portion being inserted into the insertion portion while being brought into contact with the protrusion portion. With this configuration, since the fixing portion is brought into contact with the protrusion portion while being elastically deformed and fixed, it is possible to open and close the lid portion of the cover member in a state in which the fixing portion is pressed down by the protrusion portion. For this reason, the fixing portion is pressed down by the protrusion portion, whereby it is possible to easily fix the fixing portion without providing a new configuration even in a case where the lid portion is opened and closed in a state in which the cover member is attached to the exterior surface portion.

In the power conversion device according to the above-described aspect, preferable, the lid portion covers the connection portion including a USB terminal or an SD card slot, an area of the fixing portion is smaller than an area of the lid portion as viewed from a direction in which the fixing portion is inserted, and an area of the protrusion portion is still smaller than the area of the fixing portion as viewed from the direction in which the fixing portion is inserted. With this configuration, in a case of inserting the fixing portion smaller than the lid portion into the insertion portion and fixing the fixing portion, it is possible to fix the fixing portion by providing the protrusion portion still smaller than the fixing portion. For this reason, in a case of inserting the fixing portion into the insertion portion and fixing the fixing portion, it is possible to suppress an increase in size of a device configuration due to the protrusion portion.

The foregoing and other objects, features, aspects and advantages of the present invention will become more apparent from the following detailed description of the present invention when taken in conjunction with the accompanying drawings.

### [Brief Description of the Drawings]

[Fig. 1] Fig. 1 is a schematic view showing a power conversion device according to an embodiment.
[Fig. 2] Fig. 2 is a block diagram showing the configuration of the power conversion device according to the embodiment.
[Fig. 3A] Fig. 3A is a perspective view of a cover member and an exterior surface portion according to the embodiment, and is a diagram before the cover member is attached to the exterior surface portion.
[Fig. 3B] Fig. 3B is a perspective view of the cover member and the exterior surface portion according to the embodiment, and is a diagram after the cover member is attached to the exterior surface portion.
[Fig. 4A] Fig. 4A is a plan view as the cover member and the exterior surface portion according to the embodiment are viewed from a Z1-direction side, and is a diagram before the cover member is attached to the exterior surface portion.
[Fig. 4B] Fig. 4B is a plan view as the cover member and the exterior surface portion according to the embodiment are viewed from a Z1-direction side, and a diagram after the cover member is attached to the exterior surface portion.
[Fig. 5A] Fig. 5A is a sectional view taken along the line 200-200 of Fig. 4A, and is a diagram before the cover member is attached to the exterior surface portion.
[Fig. 5B] Fig. 5B is a sectional view taken along the line 200-200 of Fig. 4B, and is a diagram after the cover member is attached to the exterior surface portion.
[Fig. 6A] Fig. 6A is a diagram illustrating a thickness of a portion of a fixing portion that is brought into contact with a protrusion portion and a distance between the protrusion portion and a second engagement portion, and is a sectional view taken along the line 200-200 of Figs. 4A and 4B.
[Fig. 6B] Fig. 6B is a diagram illustrating the thickness of the portion of the fixing portion that is brought into contact with the protrusion portion and the distance between the protrusion portion and the second engagement portion, and is a perspective view of the cover member and the exterior surface portion.
[Fig. 7A] Fig. 7A is a diagram illustrating opening and closing of a lid portion in a state of being attached to the exterior surface portion, and is a diagram showing a state in which the lid portion is closed.
[Fig. 7B] Fig. 7B is a diagram illustrating opening and closing of the lid portion in a state of being attached to the exterior surface portion, and is a diagram showing a state in which the lid portion is opened.

### [Best Mode for Carrying Out the Invention]

Hereinafter, an embodiment in which the invention is embodied will be described referring to the drawings.

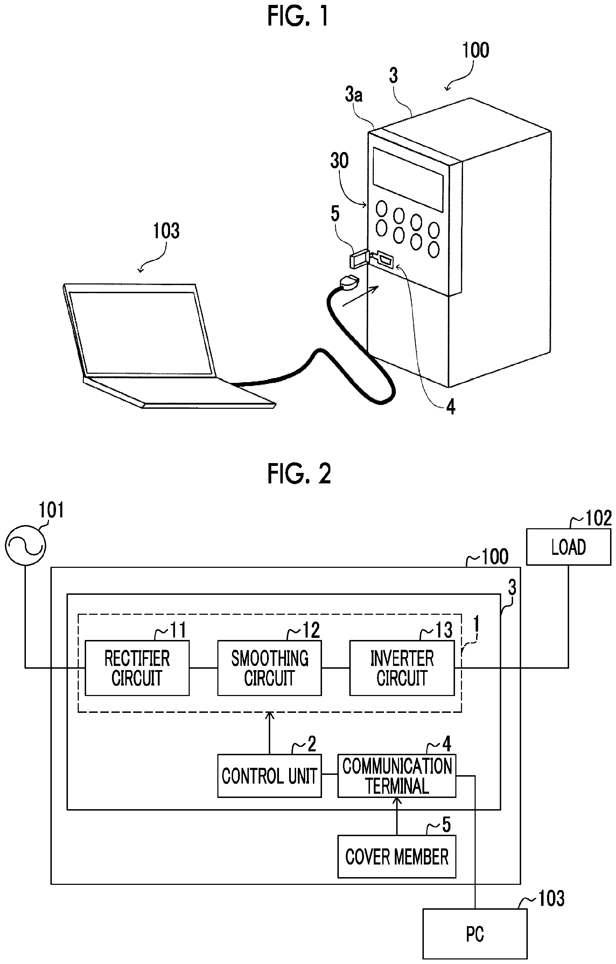

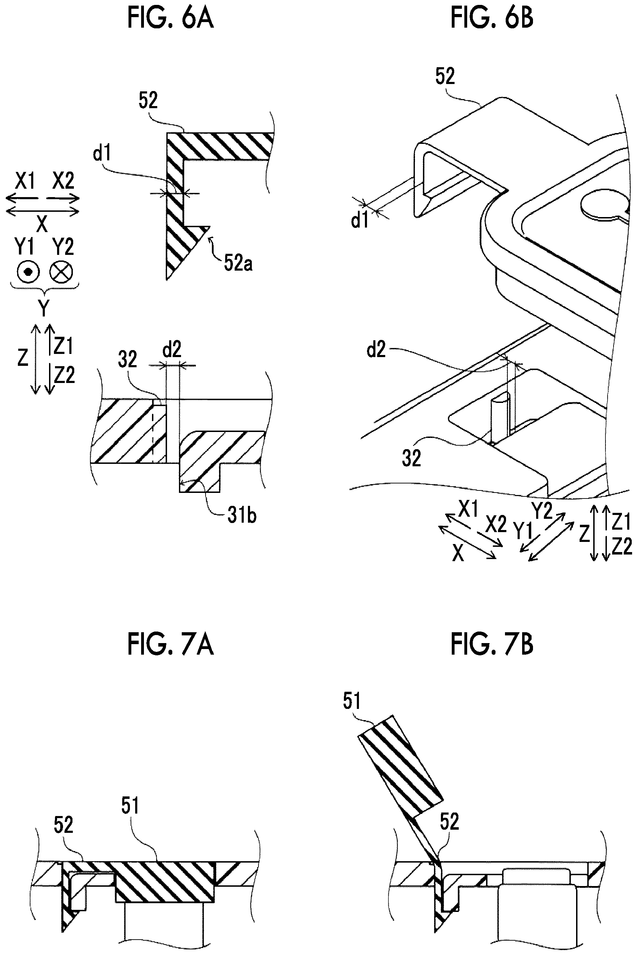

The configuration of a power conversion device 100 according to the embodiment will be described referring to Figs. 1 to 7A and 7B.

### (Overall Configuration of Power Conversion Device)

As shown in Figs. 1 and 2, the power conversion device 100 includes a power conversion unit 1, a control unit 2, a housing 3, a communication terminal 4, and a cover member 5. The power conversion device 100 is, for example, an inverter device that converts alternating-current power input from a commercial power supply 101 and outputs converted power to a load 102. As shown in Fig. 1, the power conversion device 100 is configured to perform communication with a personal computer (PC) 103. The housing 3 is an example of a "housing for power conversion" in the claims. The communication terminal 4 is an example of a "connection portion" in the claims. The PC 103 is an example of "external equipment" in the claims.

As shown in Fig. 2, the power conversion unit 1 includes a rectifier circuit 11, a smoothing circuit 12, and an inverter circuit 13. The power conversion unit 1 performs a power conversion operation to convert input power and output converted power. The rectifier circuit 11 includes a diode bridge circuit, and rectifies the alternating-current power input from the commercial power supply 101 to output direct-current power. The smoothing circuit 12 smoothes the direct-current power output from the rectifier circuit 11. The smoothing circuit 12 includes, for example, a smoothing capacitor. The inverter circuit 13 converts the smoothed direct-current power and outputs alternating-current power. The inverter circuit 13 includes, for example, a switching element, such as an insulated gate bipolar transistor (IGBT). The inverter circuit 13 converts the input direct-current power into the alternating-current power and outputs the alternating-current power by the switching element performing a switching operation under the control of the control unit 2 described below. The power conversion unit 1 may include a power factor improvement circuit that improves a power factor, a ripple elimination circuit that eliminates ripples of a current, or the like in addition to the above-described configuration.

The control unit 2 controls the power conversion operation of the power conversion unit 1. The control unit 2 includes a microcontroller having a central processing unit (CPU) and a flash memory. The control unit 2 outputs a gate signal (pulse width modulation signal (PWM signal)) for controlling the switching operation of the switching element of the inverter circuit 13 of the power conversion unit 1. The control unit 2 is configured to operate each unit of the power conversion device 100 based on set values (setting information) stored in advance in the flash memory. The control unit 2 is configured to store an operation log (history information) of the operation of each unit of the power conversion device 100 in the flash memory.

As shown in Fig. 1, in the embodiment, the housing 3 includes an operation panel 3a that is provided to control the power conversion operation of the power conversion unit 1. The operation panel 3a includes a plurality of operation buttons. Then, the operation panel 3a is configured to receive input operations based on input operations on a plurality of operation buttons. The housing 3 includes an exterior surface portion 30. Specifically, the exterior surface portion 30 is an operation surface of the operation panel 3a of the housing 3. In the housing 3, the power conversion unit 1 that performs the power conversion operation is disposed. The housing 3 is formed of, for example, ABS resin.

In the embodiment, the communication terminal 4 is provided in the exterior surface portion 30 of the housing 3. Then, the communication terminal 4 includes a USB terminal for connection of the PC 103 as external equipment. The control unit 2 and the PC 103 as external equipment transmit and receive information to and from each other through the communication terminal 4. For example, the PC 103 stores the setting information in the flash memory of the control unit 2 through the communication terminal 4 by connecting a USB cable to the communication terminal 4. The PC 103 acquires (receives) the history information stored in the flash memory of the control unit 2 through the communication terminal 4.

### (Configuration of Cover Member and Insertion Portion)

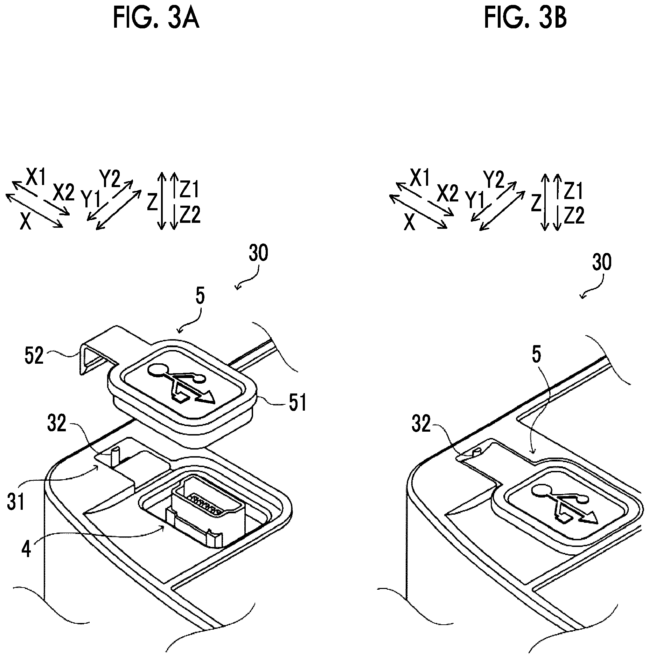

As shown in Figs. 3A and 3B, in the embodiment, the cover member 5 includes a lid portion 51 and a fixing portion 52. The lid portion 51 covers the communication terminal 4. Specifically, the lid portion 51 is provided to cover the communication terminal 4 to suppress sticking (mixing) of foreign substances, such as powder dust or dust, to the communication terminal 4. The fixing portion 52 fixes the cover member 5 to the housing 3. The fixing portion 52 is elastically deformable. For example, the fixing portion 52 is formed of elastically deforming rubber. Specifically, the lid portion 51 and the fixing portion 52 are integrally formed of elastically deforming rubber.

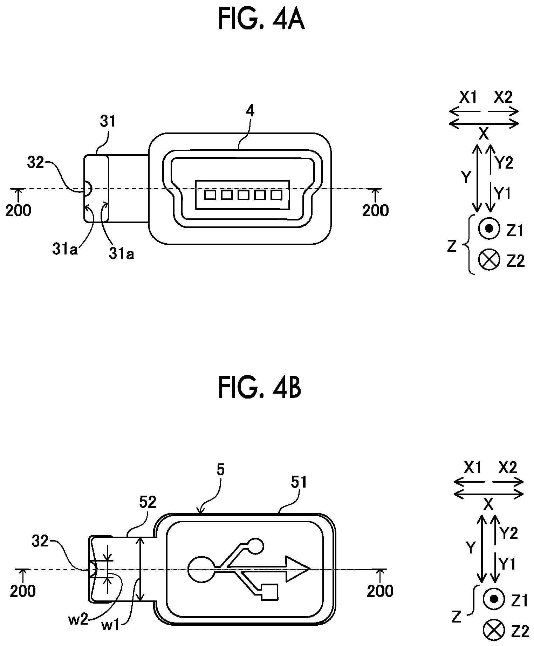

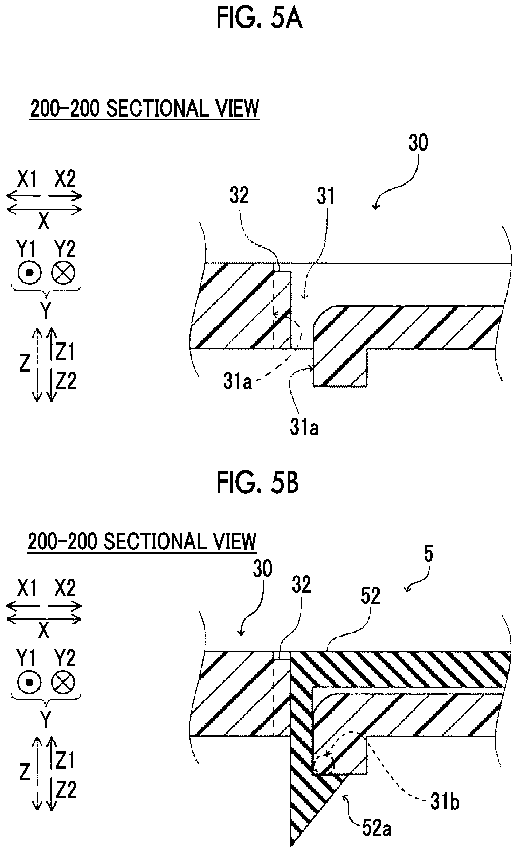

As shown in Figs. 3A and 3B to 5A and 5B, the cover member 5 is attached to the exterior surface portion 30 by the fixing portion 52 being press-fitted and inserted into an insertion portion 31 provided in the exterior surface portion 30 while being elastically deformed. The insertion portion 31 is provided in the exterior surface portion 30 separately from the communication terminal 4. As shown in Fig. 4A, the insertion portion 31 has a substantially rectangular shape as viewed from a direction (Z-direction) in which the fixing portion 52 is inserted. Specifically, the insertion portion 31 is formed to have a shape in which corners of the rectangular shape are rounded.

The fixing portion 52 has a flat plate shape (flat shape) having a section corresponding to the insertion portion 31 of the substantially rectangular shape. Then, the fixing portion 52 is bent to a long side (X2-direction side) of the insertion portion 31 in a state of being inserted into the insertion portion 31, whereby the lid portion 51 covers the communication terminal 4. That is, the fixing portion 52 has a flat shape that has a longitudinal direction in a direction (Z-direction) in which the fixing portion 52 is inserted and a transverse direction in a direction perpendicular to the direction (Z-direction) in which the fixing portion 52 is inserted and a direction (X2-direction) in which the fixing portion 52 is bent, in a state of extending in the Z direction.

As shown in Fig. 4B, in the embodiment, an area of the fixing portion 52 is smaller than an area of the lid portion 51 as viewed from the direction (Z-direction) in which the fixing portion 52 is inserted. That is, an opening area (an area as viewed from the Z-direction) of the insertion portion 31 is smaller than an area of the communication terminal 4 as viewed from the Z-direction.

As shown in Fig. 5A, in the embodiment, the insertion portion 31 provided in the exterior surface portion 30 is provided to pass through the exterior surface portion 30 in the Z-direction. That is, the insertion portion 31 is a through-hole provided in the exterior surface portion 30. The fixing portion 52 is inserted to pass through the insertion portion 31 and fixed. Specifically, as shown in Fig. 5B, the fixing portion 52 includes a wedge-shaped engagement portion 52a. Then, the engagement portion 52a is engaged with the exterior surface portion 30. An interior surface 31a (see Fig. 5A) of the insertion portion 31 on an X2-direction side has an engagement portion 31b on a Z2-direction side. That is, the fixing portion 52 is inserted into the insertion portion 31 and fixed by engagement of the engagement portion 52a with the engagement portion 31b of the insertion portion 31. The engagement portion 52a is an example of a "first engagement portion" in the claims. The engagement portion 31b is an example of a "second engagement portion" in the claims.

Here, the interior surface 31a of the insertion portion 31 means an internal peripheral wall portion (interior surface portion) of an opening of the insertion portion 31 as a through-hole. That is, the interior surface 31a of the insertion portion 31 means an internal wall surface portion of the insertion portion 31 in an X-direction and a Y-direction.

### (Configuration of Protrusion Portion)

In the embodiment, as shown in Figs. 3A and 3B to 6A and 6B, the protrusion portion 32 is provided in the interior surface 31a of the insertion portion 31 on an X1-direction side. That is, the protrusion portion 32 is provided on one side between long sides of the insertion portion 31 having the substantially rectangular shape in the interior surface 31a of the insertion portion 31. In the embodiment, the protrusion portion 32 is brought into contact with the fixing portion 52 inserted into the insertion portion 31. That is, the protrusion portion 32 is provided in the interior surface 31a on the X1-direction side to be brought into contact with the fixing portion 52 in a state in which the engagement portion 52a is engaged with the engagement portion 31b of the interior surface 31a on the X2-direction side.

As shown in Fig. 5B, in detail, in the embodiment, the protrusion portion 32 is provided in the interior surface 31a on a side opposite to the interior surface 31a in which the engagement portion 31b is provided, in the X-direction. That is, the protrusion portion 32 is provided to be brought into contact with the fixing portion 52 on one side (X1-direction side) in a direction (X-direction) perpendicular to the direction (Z-direction) in which the fixing portion 52 is inserted. On the other hand, the engagement portion 52a of the fixing portion 52 is engaged with the engagement portion 31b provided on the other side (X2-direction side) in the direction (X-direction) perpendicular to the direction (Z-direction) in which the fixing portion 52 is inserted. In other words, the fixing portion 52 is brought into contact with the protrusion portion 32 in one direction (X1-direction) of the X-direction and is engaged with the engagement portion 31b in the other direction (X2-direction) of the X-direction.

As shown in Figs. 4A and 4B, in the embodiment, the protrusion portion 32 includes a rounded surface shape. Specifically, the protrusion portion 32 has a semicircular surface shape. That is, a section of the protrusion portion 32 as viewed from the Z-direction is a semicircular shape having a circumferential portion on the X2-direction side. Accordingly, a curved surface of the protrusion portion 32 is disposed on the X2-direction side. With this, the protrusion portion 32 is brought into contact with the fixing portion 52 through the semicircular curved surface.

As shown in Fig. 4B, in the embodiment, the protrusion portion 32 has a width w2 smaller than a width w1 of the fixing portion 52 in a direction (Y-direction) perpendicular to a direction (X-direction) of being brought into contact with the fixing portion 52. Specifically, the width w2 of the protrusion portion 32 in the direction (Y-direction) perpendicular to the direction (X-direction) in which the protrusion portion 32 is brought into contact with the fixing portion 52 is shorter than the corresponding width w1 (the width in the Y-direction) of the fixing portion 52 within a plane (within an XY plane) perpendicular to the direction (Z-direction) in which the fixing portion 52 is inserted. For example, the width w1 of the fixing portion 52 in the Y-direction is about 7 mm. Then, the width w2 of the protrusion portion 32 in the Y-direction is about 1 mm. An area of the protrusion portion 32 is smaller than an area of the fixing portion 52 as viewed from the direction (Z-direction) in which the fixing portion 52 is inserted.

As shown in Figs. 5A and 5B, in the embodiment, the protrusion portion 32 is provided to extend from one end portion side (Z1-direction side) to the other end portion side (Z2-direction side) of the interior surface 31a along the direction (Z-direction) in which the fixing portion 52 is inserted. That is, the protrusion portion 32 has an elongated semicircular shape extending in the Z-direction.

As shown in Figs. 6A and 6B, in the embodiment, the protrusion portion 32 is provided in the interior surface 31a of the insertion portion 31 such that a distance d2 between the protrusion portion 32 and the engagement portion 31b is smaller than a thickness d1 of a portion of the fixing portion 52 that is brought into contact with the protrusion portion 32, in the direction (X-direction) in which the protrusion portion 32 is brought into contact with the fixing portion 52.

That is, the fixing portion 52 is in a state of being biased (pressed down) from the protrusion portion 32 in the X-direction in a state of being inserted into the insertion portion 31. That is, the fixing portion 52 is inserted into the insertion portion 31 and fixed in a state of being biased in the X-direction to be elastically deformed. Specifically, as shown in Figs. 3B and 4B, the fixing portion 52 is elastically deformed such that the portion that is brought into contact with the protrusion portion 32 is deflected, in a state in which the fixing portion 52 is inserted into the insertion portion 31. Accordingly, the fixing portion 52 is pressed down to the X2-direction side by the protrusion portion 32 and elastically deformed, whereby the fixing portion 52 is fixed in a state in which restoring force acts in the X-direction. With this, the fixing portion 52 is inserted into the insertion portion 31 and fixed in a state in which force acts in a direction of suppressing disengagement of the engagement portion 52a and the engagement portion 31b.

As described above, in the embodiment, the protrusion portion 32 is provided to be brought into contact with the fixing portion 52 inserted while being elastically deformed. Then, as shown in Figs. 7A and 7B, the cover member 5 is configured such that the lid portion 51 is openable and closeable in a state in which the cover member 5 is attached to the exterior surface portion 30, by the elastically deforming fixing portion 52 being inserted into the insertion portion 31 while being brought into contact with the protrusion portion 32. Specifically, the fixing portion 52 is elastically deformed in a state of being inserted into the insertion portion 31 and fixed, whereby a state in which the lid portion 51 is closed (Fig. 7A) is moved to a state in which the lid portion 51 is opened (Fig. 7B). That is, a connection cable (communication cable) or the like is connectable to the communication terminal 4 in a state in which the cover member 5 is attached to the exterior surface portion 30.

### (Effects of the Embodiment)

In the embodiment, it is possible to obtain the following effects.

In the embodiment, as described above, the cover member 5 is attached to the exterior surface portion 30 by the fixing portion 52 of the cover member 5 being inserted into the insertion portion 31 provided in the exterior surface portion 30 separately from the communication terminal 4 (connection portion) while being elastically deformed. Then, any one portion of the fixing portion 52 of the cover member 5 and the interior surface 31a of the insertion portion 31 provided in the exterior surface portion 30 is provided with the protrusion portion 32 that is brought into contact with the other portion and has the width w2 smaller than the width w1 of the fixing portion 52 in the direction (Y-direction) perpendicular to the direction (X-direction) of being brought into contact with the other portion. With this, the protrusion portion 32 provided in any one portion of the fixing portion 52 and the interior surface 31a of the insertion portion 31 can be brought into contact with the other portion of the fixing portion 52 and the interior surface 31a of the insertion portion 31 to press down the fixing portion 52. That is, the fixing portion 52 is press-fitted into the insertion portion 31. For this reason, unlike a case where a fastening member (screw) or the like is separately provided to fix the fixing portion 52 inserted into the insertion portion 31 is separately provided, it is possible to fix and attach the cover member 5 to the housing 3 with the interior surface 31a of the insertion portion 31 provided in the exterior surface portion 30 of the housing 3 (housing for power conversion) and the fixing portion 52 of the cover member 5 without providing a new member, such as a screw. In a case of inserting the fixing portion 52 into the insertion portion 31 and fixing the fixing portion 52, the fixing portion 52 is inserted into the insertion portion 31 while being pressed down by the protrusion portion 32 having the width w2 smaller than the width w1 of the fixing portion 52. For this reason, it is possible to reduce an area of a contact surface of the fixing portion 52 and the interior surface 31a of the insertion portion 31 with the protrusion portion 32. Since the width w2 of the protrusion portion 32 is smaller than the width w1 of the fixing portion 52, it is possible to easily elastically deform the fixing portion 52 in inserting the fixing portion 52 into the insertion portion 31. With this, since it is possible to reduce force needed for press-fitting in a case of inserting the fixing portion 52 into the insertion portion 31, it is possible to easily perform assembling work for inserting and fixing the fixing portion 52. As a result, even in a case where the cover member 5 for covering the communication terminal 4 (connection portion) for connection of the PC 103 (external equipment) is provided, it is possible to easily perform assembling work without causing an increase in the number of components to fix the cover member 5.

In the embodiment, the protrusion portion 32 provided in the interior surface 31a of the insertion portion 31 includes a rounded surface shape. With this configuration, unlike a case where corners are included in the surface shape of the protrusion portion 32, it is possible to suppress damage to the surface that is brought into contact with the protrusion portion 32, on the surface of the fixing portion 52. For this reason, it is possible to suppress deterioration of a surface portion of the fixing portion 52 due to damage caused by the corners of the protrusion portion 32.

In the embodiment, the protrusion portion 32 has the semicircular surface shape, and is provided to be brought into contact with the other portion through the semicircular curved surface of the protrusion portion 32. With this configuration, since the protrusion portion 32 is brought into contact through the semicircular curved surface, it is possible to bring the protrusion portion 32 into contact with any one portion of the fixing portion 52 and the interior surface 31a of the insertion portion 31 through line contact. For this reason, it is possible to reduce frictional force in inserting the fixing portion 52 compared to a case where the protrusion portion 32 is in surface contact with any one portion of the fixing portion 52 and the interior surface 31a of the insertion portion 31. Since the protrusion portion 32 having the semicircular surface shape is brought into contact with the fixing portion 52, it is possible to easily elastically deform the fixing portion 52 along the semicircular surface. As a result, since it is possible to further reduce the magnitude of force needed in inserting the fixing portion 52 through the semicircular surface shape of the protrusion portion 32, it is possible to more easily perform assembling work for fixing the cover member 5 by inserting the fixing portion 52 into the insertion portion 31.

In the embodiment, the protrusion portion 32 provided in the interior surface 31a of the insertion portion 31 has the width w2 in the direction (Y-direction) perpendicular to the direction in which the protrusion portion 32 is brought into contact with the other portion, smaller than the corresponding width w1 of the fixing portion 52 within the plane (within the XY plane) perpendicular to the direction (Z-direction) in which the fixing portion 52 is inserted. Here, in a case where the width w2 of the protrusion portion 32 in the direction perpendicular to the direction in which the protrusion portion 32 is brought into contact with the other portion is greater than the corresponding width w1 of the fixing portion 52 within the plane perpendicular to the direction in which the fixing portion 52 is inserted, there is a need to make the size of the opening of the insertion portion 31 greater than needed, to provide the protrusion portion 32 having a large width w2. In contrast, in the embodiment, the protrusion portion 32 is configured such that the width w2 in the direction perpendicular to the direction in which the protrusion portion 32 is brought into contact with the other portion is smaller than the corresponding width w1 of the fixing portion 52 within the plan perpendicular to the direction in which the fixing portion 52 is inserted. With this configuration, unlike a case where the protrusion portion 32 having a large width w2 is provided, since there is no need to make the size of the opening of the insertion portion 31 greater than needed, to provide the protrusion portion 32, it is possible to suppress an increase in size of a device configuration to fix the cover member 5.

In the embodiment, the protrusion portion 32 is provided in the interior surface 31a of the insertion portion 31, the fixing portion 52 includes the engagement portion 52a (first engagement portion) that is inserted into the insertion portion 31 and is engaged with the exterior surface portion 30, and the interior surface 31a of the insertion portion 31 has the engagement portion 31b (second engagement portion) that is engaged with the engagement portion 52a. With this configuration, it is possible to bring the fixing portion 52 into contact with the protrusion portion 32 provided in the interior surface 31a of the insertion portion 31 in a state in which the engagement portion 52a of the fixing portion 52 is engaged with the engagement portion 31b of the interior surface 31a of the insertion portion 31. For this reason, the protrusion portion 32 provided in the interior surface 31a of the insertion portion 31 presses the fixing portion 52, whereby it is possible to suppress disengagement of the engagement portion 52a and the engagement portion 31b. As a result, it is possible to suppress detachment of the fixing portion 52 from the insertion portion 31 with the protrusion portion 32.

In the embodiment, the insertion portion 31 is provided to pass through the exterior surface portion 30, and the protrusion portion 32 is provided in the interior surface 31a of the insertion portion 31 to be brought into contact with the fixing portion 52 in a state in which the engagement portion 52a (first engagement portion) inserted into the insertion portion 31 passing through the exterior surface portion 30 is engaged with the engagement portion 31b (second engagement portion). With this configuration, the insertion portion 31 is provided as a through-hole, whereby it is possible to insert the fixing portion 52 from one end portion to the other end portion of the through-hole to engage the engagement portion 52a with the other end portion. For this reason, unlike a case where the insertion portion 31 is a recess portion without passing through the exterior surface portion, it is possible to easily configure the interior surface 31a of the end portion of the through-hole as the engagement portion 31b by providing the insertion portion 31 as a through-hole. As a result, it is possible to easily fix the fixing portion 52 by engaging the fixing portion 52 with the insertion portion 31.

In the embodiment, the protrusion portion 32 is provided to be brought into contact with the fixing portion 52 on one side (X1-direction side) in the direction intersecting the direction in which the fixing portion 52 is inserted, in the interior surface 31a of the insertion portion 31, and the engagement portion 52a (first engagement portion) is engaged with the engagement portion 31b (second engagement portion) on the other side (X2-direction side) in the direction intersecting the direction in which the fixing portion 52 is inserted, in the interior surface 31a of the insertion portion 31. With this configuration, since the protrusion portion 32 is provided in the interior surface 31a on a side opposite to the interior surface 31a of the insertion portion 31 provided with the engagement portion 31b with which the engagement portion 52a is engaged, it is possible to fix the fixing portion 52 while pressing down the fixing portion 52 from a side opposite to the engagement portion 52a by bringing the fixing portion 52 into contact with the protrusion portion 32. For this reason, since the fixing portion 52 is pressed down from the opposite side by the protrusion portion 32, it is possible to further suppress disengagement of the engagement portion 52a and the engagement portion 31b. As a result, it is possible to further suppress detachment of the fixing portion 52 from the insertion portion 31 with the protrusion portion 32.

In the embodiment, the protrusion portion 32 is provided in the interior surface 31a of the insertion portion 31 such that the distance d2 between the protrusion portion 32 and the engagement portion 31b (second engagement portion) is smaller than the thickness d1 of the portion of the fixing portion 52 that is brought into contact with the protrusion portion 32, in the direction (X-direction) in which the protrusion portion 32 is brought into contact with the fixing portion 52. With this configuration, since the distance d2 between the protrusion portion 32 and the engagement portion 31b is smaller than the thickness d1 of the fixing portion 52, it is possible to fix the fixing portion 52 inserted into the insertion portion 31 while being brought into contact with the protrusion portion 32, while being elastically deformed by the protrusion portion 32. For this reason, it is possible to more effectively suppress disengagement of the engagement portion 52a (first engagement portion) and the engagement portion 31b (second engagement portion) with restoring force of the fixing portion 52 fixed while being elastically deformed.

In the embodiment, the insertion portion 31 has a substantially rectangular shape as viewed from the direction (Z-direction) in which the fixing portion 52 is inserted, and the protrusion portion 32 is provided on one side between long sides of the substantially rectangular shape in the interior surface 31a of the insertion portion 31. With this configuration, since the gap of the protrusion portion 32 on the long side, a portion other than the protrusion portion 32 on the long side, and the fixing portion 52 is made large compared to a case where the protrusion portion 32 is provided on the short side of the substantially rectangular shape, it is possible to elastically deform the fixing portion 52 more largely. For this reason, since the fixing portion 52 is fixed to the insertion portion 31 in a state in which greater restoring force is biased to the fixing portion 52 elastically deformed, it is possible to further suppress disengagement of the engagement portion 52a (first engagement portion) and the engagement portion 31b (second engagement portion) with greater force.

In the embodiment, the protrusion portion 32 is provided to extend from one end portion side (Z1-direction side) to the other end portion side (Z2-direction side) of the interior surface 31a along the direction (Z-direction) in which the fixing portion 52 is inserted, in the interior surface 31a of the insertion portion 31. With this configuration, it is possible to further elastically deform the fixing portion 52 compared to a case where the protrusion portion 32 is provided only in a portion in the direction in which the fixing portion 52 is inserted. For this reason, since it is possible to further bias restoring force with the fixing portion 52 further elastically deformed, it is possible to more effectively suppress disengagement of the engagement portion 52a (first engagement portion) and the engagement portion 31b (second engagement portion).

In the embodiment, the housing 3 (housing for power conversion) includes the operation panel 3a that controls the power conversion operation of the power conversion unit 1, and the protrusion portion 32 is provided in the interior surface 31a of the insertion portion 31 provided in the exterior surface portion 30 as the operation surface of the operation panel 3a. With this configuration, even in a case where the communication terminal 4 (connection portion) for connection of the external equipment is provided in the operation surface of the operation panel 3a where the power conversion operation is controlled, it is possible to easily fix the cover member 5 without providing a new configuration (member). For this reason, it is possible to easily perform assembling work of the operation panel 3a without causing an increase in the number of components of the operation panel 3a.

In the embodiment, the cover member 5 includes the fixing portion 52 formed of elastically deforming rubber and is attached to the exterior surface portion 30 by the fixing portion 52 being press-fitted and inserted into the insertion portion 31 while being elastically deformed, and the protrusion portion 32 is provided in the interior surface 31a of the insertion portion 31 and is provided to be brought into contact with the fixing portion 52 inserted while being elastically deformed. With this configuration, since the fixing portion 52 is formed of rubber, it is possible to easily elastically deform the fixing portion 52. For this reason, since it is possible to easily elastically deform and press down the fixing portion 52 in a state of being brought into contact with the protrusion portion 32, it is possible to easily fix and attach the cover member 5 to the housing 3 (housing for power conversion).

In the embodiment, the cover member 5 is configured such that the lid portion 51 is openable and closeable in a state in which the cover member 5 is attached to the exterior surface portion 30, by the elastically deforming fixing portion 52 being inserted into the insertion portion 31 while being brought into contact with the protrusion portion 32. With this configuration, since the fixing portion 52 is brought into contact with the protrusion portion 32 while being elastically deformed and fixed, it is possible to open and close the lid portion 51 of the cover member 5 in a state in which the fixing portion 52 is pressed down by the protrusion portion 32. For this reason, the fixing portion 52 is pressed down by the protrusion portion 32, whereby it is possible to easily fix the fixing portion 52 without providing a new configuration even in a case where the lid portion 51 is opened and closed in a state in which the cover member 5 is attached to the exterior surface portion 30.

In the embodiment, the lid portion 51 covers the communication terminal 4 (connection portion) including the USB terminal or the SD card slot, the area of the fixing portion 52 is smaller than the area of the lid portion 51 as viewed from the direction in which the fixing portion 52 is inserted, and the area of the protrusion portion 32 is still smaller than the area of the fixing portion 52 as viewed from the direction in which the fixing portion 52 is inserted. With this configuration, in a case of inserting the fixing portion 52 smaller than the lid portion 51 into the insertion portion 31 and fixing the fixing portion 52, it is possible to fix the fixing portion 52 by providing the protrusion portion 32 still smaller than the fixing portion 52. For this reason, in a case of inserting the fixing portion 52 into the insertion portion 31 and fixing the fixing portion 52, it is possible to suppress an increase in size of a device configuration due to the protrusion portion 32.

## Claims

1. A power conversion device (100) comprising:
a housing for power conversion (3) that includes an exterior surface portion (30) provided with a connection portion (4) for connection of external equipment (103) and in which a power conversion unit (1) configured to perform a power conversion operation to convert input power and output converted power is disposed; and
a cover member (5) including a lid portion (51) for covering the connection portion (4) and an elastically deformable fixing portion (52) for fixing the cover member (5) to the housing for power conversion (3),
wherein the cover member (5) is configured to be attached to the exterior surface portion (30) by the fixing portion (52) being inserted and press-fitted into an insertion portion (31) provided in the exterior surface portion (30) separately from the connection portion (4) while being elastically deformed,
**characterised in that**
any one portion of the fixing portion of the cover member and an interior surface (31a) of the insertion portion (31) provided in the exterior surface portion (30) is provided with a protrusion portion (32) that is configured to be brought into contact with the other portion (52) and has a width smaller than a width of the fixing portion (52) in a direction perpendicular to a direction in which the protrusion portion (32) is brought into contact with the other portion (52),
the fixing portion (52) is provided with a first engagement portion (52a) configured to be inserted into the insertion portion (31) and to be engaged with the exterior surface portion (30) in opposite side to the protrusion portion (32).

2. The power conversion device according to claim 1,
wherein the protrusion portion (32) provided in any one portion of the fixing portion and the interior surface (31a) of the insertion portion (31) has a surface shape with chamfered corners or a rounded surface shape.

3. The power conversion device according to claim 2,
wherein the protrusion portion (32) has a semicircular surface shape and is provided to be brought into contact with the other portion (52) through a semicircular curved surface of the protrusion portion (32).

4. The power conversion device according to any one of claims 1 to 3,
wherein the protrusion portion (32) provided in any one portion of the fixing portion and the interior surface (31a) of the insertion portion (31) has a width in a direction perpendicular to a direction in which the protrusion portion (32) is brought into contact with the other portion (52), smaller than a corresponding width of the fixing portion (52) within a plane perpendicular to a direction in which the fixing portion (52) is inserted.

5. The power conversion device according to any one of claims 1 to 4,
wherein the protrusion portion (32) is provided in the interior surface (31a) of the insertion portion (31),
the fixing portion (52) includes a first engagement portion (52a) that is inserted into the insertion portion (31) and is engaged with the exterior surface portion (30), and
the interior surface (31a) of the insertion portion (31) has a second engagement portion (31a) that is engaged with the first engagement portion.

6. The power conversion device according to claim 5,
wherein the insertion portion (31) is provided to pass through the exterior surface portion (30), and
the protrusion portion (32) is provided in the interior surface (31a) of the insertion portion (31) to be brought into contact with the fixing portion (52) in a state in which the first engagement portion inserted into the insertion portion (31) passing through the exterior surface portion (30) is engaged with the second engagement portion.

7. The power conversion device according to claim 5 or 6,
wherein the protrusion portion (32) is provided to be brought into contact with the fixing portion (52) on one side in a direction intersecting a direction in which the fixing portion (52) is inserted, in the interior surface (31a) of the insertion portion (31), and
the first engagement portion is engaged with the second engagement portion provided on the other side in the direction intersecting the direction in which the fixing portion (52) is inserted, in the interior surface (31a) of the insertion portion (31).

8. The power conversion device according to any one of claims 5 to 7,
wherein the protrusion portion (32) is provided in the interior surface (31a) of the insertion portion (31) such that a distance between the protrusion portion (32) and the second engagement portion is smaller than a thickness of a portion of the fixing portion (52) that is brought into contact with the protrusion portion (32) in a direction in which the protrusion portion (32) is brought into contact with the fixing portion (52).

9. The power conversion device according to any one of claims 5 to 8,
wherein the insertion portion (31) has a rectangular shape as viewed from a direction in which the fixing portion (52) is inserted, and
the protrusion portion (32) is provided on one side between long sides of the rectangular shape in the interior surface (31a) of the insertion portion (31).

10. The power conversion device according to any one of claims 5 to 9,
wherein the protrusion portion (32) is provided to extend from one end portion side to the other end portion side of the interior surface (31a) of the insertion portion (31) along a direction in which the fixing portion (52) is inserted, in the interior surface (31a) of the insertion portion (31).

11. The power conversion device according to any one of claims 1 to 10,
Wherein the housing for power conversion (3) includes an operation panel (3a) that controls the power conversion operation of the power conversion unit, and
the protrusion portion (32) is provided in the interior surface (31a) of the insertion portion (31) provided in the exterior surface portion (30) as an operation surface of the operation panel.

12. The power conversion device according to any one of claims 1 to 11,
wherein the cover member (5) includes the fixing portion (52) formed of elastically deforming rubber and is attached to the exterior surface portion (30) by the fixing portion (52) being press-fitted and inserted into the insertion portion (31) while being elastically deformed, and
the protrusion portion (32) is provided in the interior surface (31a) of the insertion portion (31) and is provided to be brought into contact with the fixing portion (52) inserted while being elastically deformed.

13. The power conversion device according to claim 12,
wherein the cover member (5) is configured such that the lid portion (51) is openable and closeable in a state in which the cover member (5) is attached to the exterior surface portion (30), by the elastically deforming fixing portion (52) being inserted into the insertion portion (31) while being brought into contact with the protrusion portion (32).

14. The power conversion device according to any one of claims 1 to 13,
wherein the lid portion (51) covers the connection portion (4) including a USB terminal or an SD card slot,
an area of the fixing portion (52) is smaller than an area of the lid portion (51) as viewed from a direction in which the fixing portion (52) is inserted, and
an area of the protrusion portion (32) is still smaller than the area of the fixing portion (52) as viewed from the direction in which the fixing portion (52) is inserted.

## Patentansprüche

1. Stromumwandlungsvorrichtung (100), umfassend:
ein Gehäuse für Stromumwandlung (3), das einen äußeren Flächenabschnitt (30) umfasst, der mit einem Verbindungsabschnitt (4) zum Verbinden einer externen Ausrüstung (103) versehen ist und in dem eine Stromumwandlungseinheit (1) angeordnet ist, die konfiguriert ist, einen Stromumwandlungsvorgang auszuführen, um Eingangsstrom umzuwandeln und umgewandelten Strom auszugeben; und
ein Abdeckungselement (5), das einen Deckelabschnitt (51) zum Abdecken des Verbindungsabschnitts (4) und einen elastisch verformbaren Befestigungsabschnitt (52) zum Befestigen des Abdeckungselements (5) an dem Gehäuse für Energieumwandlung (3) umfasst,
wobei das Abdeckungselement (5) konfiguriert ist, an dem äußeren Flächenabschnitt (30) angebracht zu werden, indem der Befestigungsabschnitt (52) in einen Einführungsabschnitt (31), der getrennt von dem Verbindungsabschnitt (4) in dem äußeren Flächenabschnitt (30) vorgesehen ist, eingeführt und eingepresst wird, während er elastisch verformt wird,
**dadurch gekennzeichnet, dass**
irgendein Abschnitt des Befestigungsabschnitts des Abdeckungselements und eine Innenfläche (31a) des Einführungsabschnitts (31), die in dem äußeren Flächenabschnitt (30) vorgesehen ist, mit einem Vorsprungsabschnitt (32) versehen ist, der konfiguriert ist, mit dem anderen Abschnitt (52) in Kontakt gebracht zu werden, und eine Breite aufweist, die in einer Richtung senkrecht zu einer Richtung, in welcher der Vorsprungsabschnitt (32) mit dem anderen Abschnitt (52) in Kontakt gebracht ist, kleiner ist als eine Breite des Befestigungsabschnitts (52),
der Befestigungsabschnitt (52) mit einem ersten Eingriffsabschnitt (52a) versehen ist, der konfiguriert ist, in den Einführungsabschnitt (31) eingeführt und mit dem äußeren Flächenabschnitt (30) auf der dem Vorsprungsabschnitt (32) entgegengesetzten Seite in Eingriff gebracht zu werden.

2. Stromumwandlungsvorrichtung nach Anspruch 1,
wobei der Vorsprungsabschnitt (32), der in irgendeinem Abschnitt des Befestigungsabschnitts vorgesehen ist, und die Innenfläche (31a) des Einführungsabschnitts (31) eine Flächenform mit abgeschrägten Ecken oder eine abgerundete Flächenform aufweisen.

3. Stromumwandlungsvorrichtung nach Anspruch 2,
wobei der Vorsprungsabschnitt (32) eine halbkreisförmige Flächenform aufweist und vorgesehen ist, mit dem anderen Abschnitt (52) über eine halbkreisförmige gekrümmte Fläche des Vorsprungsabschnitts (32) in Kontakt gebracht zu werden.

4. Stromumwandlungsvorrichtung nach einem der Ansprüche 1 bis 3,
wobei der Vorsprungsabschnitt (32), der in irgendeinem Abschnitt des Befestigungsabschnitts und der Innenfläche (31a) des Einführungsabschnitts (31) vorgesehen ist, in einer Richtung senkrecht zu einer Richtung, in welcher der Vorsprungsabschnitt (32) mit dem anderen Abschnitt (52) in Kontakt gebracht ist, eine Breite aufweist, die kleiner ist als eine entsprechende Breite des Befestigungsabschnitts (52) innerhalb einer Ebene senkrecht zu einer Richtung, in welcher der Befestigungsabschnitt (52) eingeführt ist.

5. Stromumwandlungsvorrichtung nach einem der Ansprüche 1 bis 4,
wobei der Vorsprungsabschnitt (32) in der Innenfläche (31a) des Einführungsabschnitts (31) vorgesehen ist,
der Befestigungsabschnitt (52) einen ersten Eingriffsabschnitt (52a) umfasst, der in den Einführungsabschnitt (31) eingeführt ist und mit dem äußeren Flächenabschnitt (30) in Eingriff steht, und
die Innenfläche (31a) des Einführungsabschnitts (31) einen zweiten Eingriffsabschnitt (31a) aufweist, der mit dem ersten Eingriffsabschnitt in Eingriff steht.

6. Stromumwandlungsvorrichtung nach Anspruch 5,
wobei der Einführungsabschnitt (31) derart vorgesehen ist, dass er durch den äußeren Flächenabschnitt (30) hindurchgeht, und
der Vorsprungsabschnitt (32) in der Innenfläche (31a) des Einführungsabschnitts (31) vorgesehen ist, der mit dem Befestigungsabschnitt (52) in einem Zustand in Kontakt zu bringen ist, in dem der erste Eingriffsabschnitt, der in den Einführungsabschnitt (31) eingeführt ist, der durch den äußeren Flächenabschnitt (30) hindurchgeht, mit dem zweiten Eingriffsabschnitt in Eingriff steht.

7. Stromumwandlungsvorrichtung nach Anspruch 5 oder 6,
wobei der Vorsprungsabschnitt (32) derart vorgesehen ist, dass er mit dem Befestigungsabschnitt (52) auf einer Seite in einer Richtung in Kontakt zu bringen ist, die eine Richtung schneidet, in welcher der Befestigungsabschnitt (52) in die Innenfläche (31a) des Einführungsabschnitts (31) eingeführt ist, und
der erste Eingriffsabschnitt mit dem zweiten Eingriffsabschnitt in Eingriff steht, der auf der anderen Seite in der Richtung, welche die Richtung schneidet, in welcher der Befestigungsabschnitt (52) eingeführt ist, in der Innenfläche (31a) des Einführungsabschnitts (31) vorgesehen ist.

8. Stromumwandlungsvorrichtung nach einem der Ansprüche 5 bis 7,
wobei der Vorsprungsabschnitt (32) in der Innenfläche (31a) des Einführungsabschnitts (31) derart vorgesehen ist, dass ein Abstand zwischen dem Vorsprungsabschnitt (32) und dem zweiten Eingriffsabschnitt kleiner ist als eine Dicke eines Abschnitts des Befestigungsabschnitts (52), der in einer Richtung, in welcher der Vorsprungsabschnitt (32) mit dem Befestigungsabschnitt (52) in Kontakt gebracht ist, mit dem Vorsprungsabschnitt (32) in Kontakt gebracht ist.

9. Stromumwandlungsvorrichtung nach einem der Ansprüche 5 bis 8,
wobei der Einführungsabschnitt (31) von einer Richtung gesehen, in welcher der Befestigungsabschnitt (52) eingeführt ist, eine rechteckige Form aufweist und
der Vorsprungsabschnitt (32) auf einer Seite zwischen langen Seiten der rechteckigen Form in der Innenfläche (31a) des Einführungsabschnitts (31) vorgesehen ist.

10. Stromumwandlungsvorrichtung nach einem der Ansprüche 5 bis 9,
wobei der Vorsprungsabschnitt (32) derart vorgesehen ist, dass er sich von einer Endabschnittseite zu der anderen Endabschnittseite der Innenfläche (31a) des Einführungsabschnitts (31) entlang einer Richtung, in welcher der Befestigungsabschnitt (52) eingeführt ist, in der Innenfläche (31a) des Einführungsabschnitts (31) erstreckt.

11. Stromumwandlungsvorrichtung nach einem der Ansprüche 1 bis 10,
wobei das Gehäuse für Stromumwandlung (3) ein Bedienfeld (3a) umfasst, das den Stromumwandlungsvorgang der Stromumwandlungseinheit steuert, und
der Vorsprungsabschnitt (32) in der Innenfläche (31a) des in dem äußeren Flächenabschnitt (30) vorgesehenen Einführungsabschnitts (31) als eine Bedienfläche des Bedienfelds vorgesehen ist.

12. Stromumwandlungsvorrichtung nach einem der Ansprüche 1 bis 11,
wobei das Abdeckungselement (5) den aus elastisch verformbarem Gummi gebildeten Befestigungsabschnitt (52) umfasst und an dem äußeren Flächenabschnitt (30) angebracht ist, indem der Befestigungsabschnitt (52) in den Einführungsabschnitt (31) eingepresst und eingeführt ist, während er elastisch verformt ist, und
der Vorsprungsabschnitt (32) in der Innenfläche (31a) des Einführungsabschnitts (31) vorgesehen ist und vorgesehen ist, mit dem Befestigungsabschnitt (52) in Kontakt gebracht zu werden, während er elastisch verformt ist.

13. Stromumwandlungsvorrichtung nach Anspruch 12,
wobei das Abdeckungselement (5) derart konfiguriert ist, dass der Deckelabschnitt (51) in einem Zustand, in dem das Abdeckungselement (5) an dem äußeren Flächenabschnitt (30) angebracht ist, geöffnet und geschlossen werden kann, indem der sich elastisch verformende Befestigungsabschnitt (52) in den Einführungsabschnitt (31) eingeführt wird, während er mit dem Vorsprungsabschnitt (32) in Kontakt gebracht wird.

14. Stromumwandlungsvorrichtung nach einem der Ansprüche 1 bis 13,
wobei der Deckelabschnitt (51) den Verbindungsabschnitt (4) einschließlich eines USB-Anschlusses oder eines SD-Kartensteckplatzes abdeckt,
ein Bereich des Befestigungsabschnitts (52) aus einer Richtung gesehen, in welcher der Befestigungsabschnitt (52) eingeführt ist, kleiner ist als ein Bereich des Deckelabschnitts (51) und
ein Bereich des Vorsprungsabschnitts (32) aus der Richtung gesehen, in welcher der Befestigungsabschnitt (52) eingeführt ist, noch kleiner ist als der Bereich des Befestigungsabschnitts (52).

## Revendications

1. Dispositif de conversion de puissance (100) comprenant :
une enceinte destinée à la conversion de puissance (3) qui comprend une partie de surface extérieure (30) équipée d'une partie de liaison (4) destinée au raccordement d'un équipement externe (103) et dans laquelle est prévue une unité de conversion de puissance (1) configurée pour effectuer une opération de conversion de puissance afin de convertir une puissance d'entrée et de délivrer une puissance convertie ; et
un capot (5) comprenant une partie de couvercle (51) destinée à recouvrir la partie de liaison (4) et une partie de fixation élastiquement déformable (52) destinée à fixer le capot (5) sur l'enceinte pour la conversion de puissance (3),
dans lequel le capot (5) est configuré pour être fixé sur la partie de surface extérieure (30) par la partie de fixation (52) qui est insérée et ajustée de force dans une partie d'insertion (31) prévue dans la partie de surface extérieure (30) séparément de la partie de liaison (4) tout en étant élastiquement déformée,
**caractérisé en ce que** n'importe quelle partie de la partie de fixation du capot et d'une surface intérieure (31a) de la partie d'insertion (31) prévue dans la partie de surface extérieure (30) est équipée d'une partie de saillie (32) qui est configurée pour être amenée en contact avec l'autre partie (52) et présente une largeur inférieure à une largeur de la partie de fixation (52) dans une direction perpendiculaire à une direction dans laquelle la partie de saillie (32) est amenée en contact avec l'autre partie (52),
la partie de fixation (52) est équipée d'une première partie d'engagement (52a) configurée pour être insérée dans la partie d'insertion (31) et pour être engagée avec la partie de surface extérieure (30) sur un côté opposé à la partie de saillie (32).

2. Dispositif de conversion de puissance selon la revendication 1,
dans lequel la partie de saillie (32) prévue dans n'importe quelle partie de la partie de fixation et de la partie de surface extérieure (31a) de la partie d'insertion (31) présente une forme de surface avec des angles chanfreinés ou une forme de surface arrondie.

3. Dispositif de conversion de puissance selon la revendication 2,
dans lequel la partie de saillie (32) présente une forme de surface semicirculaire et est prévue pour être amenée en contact avec l'autre partie (52) par le biais d'une surface incurvée semicirculaire de la partie de saillie (32).

4. Dispositif de conversion de puissance selon l'une quelconque des revendications 1 à 3,
dans lequel la partie de saillie (32) prévue dans n'importe quelle partie de la partie de fixation et de la partie de surface intérieure (31a) de la partie d'insertion (31) présente une largeur dans une direction perpendiculaire à une direction dans laquelle la partie de saillie (32) est amenée en contact avec l'autre partie (52), inférieure à une largeur correspondante de la partie de fixation (52) sur un plan perpendiculaire à une direction dans laquelle la partie de fixation (52) est insérée.

5. Dispositif de conversion de puissance selon l'une quelconque des revendications 1 à 4,
dans lequel la partie de saillie (32) est prévue dans la surface intérieure (31a) de la partie d'insertion (31),
la partie de fixation (52) comprend une première partie d'engagement (52a) qui est insérée dans la partie d'insertion (31) et est engagée avec la partie de surface extérieure (30), et
la surface intérieure (31a) de la partie d'insertion (31) possède une seconde partie d'engagement (31a) qui est engagée avec la première partie d'engagement.

6. Dispositif de conversion de puissance selon la revendication 5,
dans lequel la partie d'insertion (31) est prévue pour passer à travers la partie de surface extérieure (30), et
la partie de saillie (32) est prévue dans la surface intérieure (31a) de la partie d'insertion (31) afin d'être amenée en contact avec la partie de fixation (52) dans un état dans lequel la première partie d'engagement insérée dans la partie d'insertion (31) qui passe à travers la partie de surface extérieure (30) est engagée avec la seconde partie d'engagement.

7. Dispositif de conversion de puissance selon la revendication 5 ou 6,
dans lequel la partie de saillie (32) est prévue pour être amenée en contact avec la partie de fixation (52) sur un côté dans une direction qui croise une direction dans laquelle la partie de fixation (52) est insérée, dans la surface intérieure (31a) de la partie d'insertion (31), et
la première partie d'engagement est engagée avec la seconde partie d'engagement prévue sur l'autre côté dans la direction qui croise la direction dans laquelle la partie de fixation (52) est insérée, dans la surface intérieure (31a) de la partie d'insertion (31).

8. Dispositif de conversion de puissance selon l'une quelconque des revendications 5 à 7,
dans lequel la partie de saillie (32) est prévue dans la surface intérieure (31a) de la partie d'insertion (31) de sorte qu'une distance entre la partie de saillie (32) et la seconde partie d'engagement soit inférieure à une épaisseur d'une partie de la partie de fixation (52) qui est amenée en contact avec la partie de saillie (32) dans une direction dans laquelle la partie de saillie (32) est amenée en contact avec la partie de fixation (52).

9. Dispositif de conversion de puissance selon l'une quelconque des revendications 5 à 8,
dans lequel la partie d'insertion (31) possède une forme rectangulaire lorsqu'elle est vue dans une direction dans laquelle la partie de fixation (52) est insérée, et
la partie de saillie (32) est prévue sur un côté entre les côtés longs de la forme rectangulaire dans la surface intérieure (31a) de la partie d'insertion (31).

10. Dispositif de conversion de puissance selon l'une quelconque des revendications 5 à 9,
dans lequel la partie de saillie (32) est prévue pour s'étendre depuis une partie d'extrémité jusqu'à l'autre partie d'extrémité de la surface intérieure (31a) de la partie d'insertion (31) le long d'une direction dans laquelle la partie de fixation (52) est insérée, dans la surface intérieure (31a) de la partie d'insertion (31).

11. Dispositif de conversion de puissance selon l'une quelconque des revendications 1 à 10,
dans lequel l'enceinte destinée à la conversion de puissance (3) comprend un panneau de commande (3a) qui contrôle l'opération de conversion de puissance de l'unité de conversion de puissance, et
la partie de saillie (32) est prévue dans la surface intérieure (31a) de la partie d'insertion (31) prévue dans la partie de surface extérieure (30) en guise de surface de fonctionnement du panneau de commande.

12. Dispositif de conversion de puissance selon l'une quelconque des revendications 1 à 11,
dans lequel le capot (5) comprend la partie de fixation (52) formée de caoutchouc déformable élastiquement et est fixé sur la partie de surface extérieure (30) par la partie de fixation (52) ajustée de force et insérée dans la partie d'insertion (31) tout en étant élastiquement déformée, et
la partie de saillie (32) est prévue dans la surface intérieure (31a) de la partie d'insertion (31) et est prévue pour être amenée en contact avec la partie de fixation (52) insérée tout en étant élastiquement déformée.

13. Dispositif de conversion de puissance selon la revendication 12,
dans lequel le capot (5) est configuré de sorte que la partie de couvercle (51) puisse être ouverte et fermée dans un état dans lequel le capot (5) est fixé sur la partie de surface extérieure (30), par la partie de fixation qui se déforme élastiquement (52) qui est insérée dans la partie d'insertion (31) tout en étant amenée en contact avec la partie de saillie (32).

14. Dispositif de conversion de puissance selon l'une quelconque des revendications 1 à 13,
dans lequel la partie de couvercle (51) recouvre la partie de liaison (4) comprenant une prise USB ou un slot pour carte SD,
une surface de la partie de fixation (52) est inférieure à une surface de la partie de couvercle (51) lorsqu'elle est vue depuis une direction dans laquelle la partie de fixation (52) est insérée, et
une surface de la partie de saillie (32) reste inférieure à la surface de la partie de fixation (52) lorsqu'elle est vue depuis la direction dans laquelle la partie de fixation (52) est insérée.
